# EUROPEAN PATENT APPLICATION

(11) **EP 1 220 326 A1**
(43) Date of publication of application: **03.07.2002**
(21) Application number: 00204618.3
(22) Date of filing: 19.12.2000
(51) Int. Cl.: H01L 31/04, H01L 51/20

(54) **Thermophotovoltaic conversion module with an organic photocell**

(71) Applicant: ABB Research Ltd., 8050 Zürich (CH)
(72) Inventor: Malfa, Enrico, 24059 Zanica (BG) (IT); Sciacca, Aldo, 20097 San Donato Milanese (MI) (IT)
(74) Representative: Giavarini, Francesco

(57) **Abstract**

A TPV conversion module for generating electric power comprising an emitter body, which emits IR radiation, when said emitter body is heated by the hot gases generated by a burner device and a receiver body, which is associated to said emitter body. The receiver body comprises one or more TPV cells, which include a multi-layered structure, provided with at least a layer of organic material.

## Description

The present invention relates to an improved thermophotovoltaic (TPV) conversion module.

More particularly, the present invention relates to an improved TPV conversion module, which is suitable for the use in systems for the distributed generation of electric power.

It is known that systems for the distributed generation of electric power have had a large diffusion in the market, in the last years. Distributed generation (DG) systems are mainly aimed at generating electric power in the proximity of the final user, avoiding the need of an electric power distribution network.

Distributed generation of electric power is generally adopted also in combined-heat-power (CHP) systems and in combined-heat-cold-power (CHCP) systems, which refer to the simultaneous production of electric power, hot water and steam for heating or cooling purposes.

A wide range of electric power may be covered: from few hundreds watts (domestic applications) to several megawatts (huge industrial plants), depending on the needs.

In the past, there have been, in the field of the distributed generation, different types of electric power generation methods, which employ generally internal combustion engines (ICE) or turbo-machines.

These traditional methods have some disadvantages, which are mainly related to the fact of using apparatuses, provided with moving parts and, therefore, subjected to wear problems, high noise levels, frequent maintenance interventions and the like.

Beside these traditional methods, some alternative methods, which imply a "static" generation of electric power, have been developed. Among these, the methods, which adopt solar photovoltaic (PV) conversion for generating electric power, have to be mentioned. Solar photovoltaic converters are extensively used in low-medium scale electric power distributed generation systems. Thanks to absence of moving parts, they allow overcoming most of the disadvantages that are proper of the methods employing ICE or turbo-machines.

Similarly to the PV conversion, also to the TPV electric power conversion prevents from the use of moving parts within an electric power generator. In fact, TPV electric power generation is based upon the positioning semiconductor TPV cells, which are structured similarly to the well known solar cells, in the photon flux field of a high temperature photon emitter. In practice, TPV electric power generation is based on the conversion of infrared (IR) radiation, which is emitted by a heat source. The development of emitters, able to emit a narrowband IR radiation, and the adoption of TPV cells, made of selected semiconductor compounds, such as those of the III-V families (GaAs, GaSb, InGaSb, InGaAsSb and the like), have allowed reaching high power density levels (higher than 1W/cm²). Therefore, TPV electric power generation has shown to be attractive for the relatively low size and the relatively reduced installation and maintenance costs of the TPV generation systems, keeping unchanged, at the same time, the advantages that are proper of the PV technology.

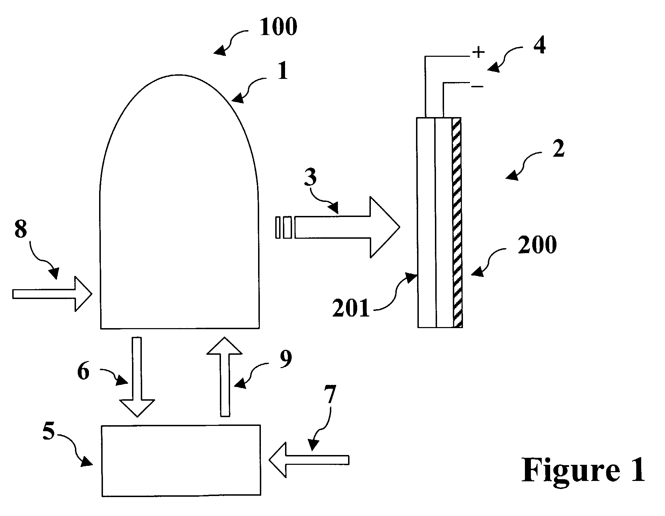

Traditionally, TPV generation systems adopt a configuration, which is similar to that one illustrated in figure 1. A TPV apparatus comprises a TPV conversion module 100 that includes an emitter 1, which is provided generally with a cylindrical structure, similar to the radiant tubes that are traditionally used in industrial kiln-drying systems. The emitter 1 is associated to a burner (not illustrated) which generally constitutes the heat source and is supplied with fuel 8 and combustion air 7. The combustion process obviously provokes the emission of hot gases from the burner. These hot gases are provided with a certain amount thermal power, which increases the temperature of the emitter 1. Thus, the emitter 1 emits externally IR photons 3. Further, a TPV conversion module comprises also a receiver 200, which comprises semiconductor TPV cells arrays 201 for converting the IR radiation 3 into electric power 4. A recuperator 5 is generally associated to the burner. The recuperator 5 recovers the residual heat of the flue gases 6 in order to increase the whole efficiency of the conversion system. In fact, by means of heat exchangers, it is possible to pre-heat the air, which is used for the combustion (the pre-heated air flux is represented by arrow 9).

Unfortunately, traditional TPV systems are affected by some drawbacks.

A first drawback is due the relatively high production costs of the TPV conversion modules that are generally adopted. As mentioned, a traditional TPV conversion module comprises TPV cells that are made of inorganic semiconductor compounds. TPV cells are manufactured adopting technologies that derive from the semiconductor industry. A traditional manufacturing technique is substantially based on the epitaxial growth of semiconductor layers (generally made of AlGaAs or InGaAs or InGaAsSb) on a semiconductor substrate (generally made of GaAs, InP or GaSb). This manufacturing technique is quite sophisticated and requires expensive apparatuses, skilled personnel and expensive time-consuming manufacturing procedures. Thus, in practice, this manufacturing technique is use for high value and high cost applications, only. An alternative traditional manufacturing technique is based on the diffusion of dopants on a suitable semiconductor substrate (generally made of GaSb). This manufacturing technique requires cheaper arrangements and, for this reason, is widely adopted for production of TPV cells. However, manufacturing costs are still relatively high and massive production volumes are needed for achieving reasonable cost targets.

Another important drawback derives from the fact that the use of inorganic semiconductor cells intrinsically implies severe constraints to the design of a TPV module. For example, due to the fact that TPV cells have small size due to manufacturing constraints (e.g. intensive utilization of the wafer available surface), a large number of TPV cells have to be serially connected in order to achieve satisfactory levels of output electric power. This requires setting up complicated circuit arrangements. Further, the overall weight of the TPV conversion module is often quite remarkable and, therefore, the assembly of a TPV apparatus, which comprises one or more TPV conversion modules, may be quite difficult. Moreover, inorganic TPV cells are intrinsically rigid and, therefore, it is very difficult to dispose them of curved surfaces. In a TPV conversion module, this may provoke a decrease of the power density with reference to the power transmitted from the emitter body to the receiver body and, consequently, a decrease of the overall conversion efficiency.

Finally, the realization of inorganic TPV cells provided with multi-layered structures, which would improve the conversion efficiency of the TPV conversion module, is quite difficult and expensive, due to the fact that complicated manufacturing technologies have to be adopted.

In practice, one can state that the use of inorganic TPV cells, in traditional TPV conversion modules, does not allow achieving fully satisfactory performances in terms of manufacturing costs, design flexibility and performances, yet.

Therefore, the main aim of the present invention is to provide a TPV conversion module, which allows overcoming the mentioned drawbacks. Within this aim, an object of the present invention is to provide a TPV conversion module, which can be manufactured with relatively low-cost processes.

Another object of the present invention is to provide a TPV conversion module, which can be designed with a high level of flexibility and reliability.

Another object of the present invention is to provide a TPV conversion module, which allows achieving improved performances, particularly in terms of conversion efficiency.

Thus, the present invention provides a TPV conversion module, which comprises an emitter body, which is associated to a burner device that generates hot gases provided with an amount of thermal power. The emitter body comprises at least an emitting surface, which emits IR radiation, when the emitter body is heated by said hot gases. Further, the TPV conversion module, according to the present invention, further comprises a receiver body, which is associated to the emitter body. The receiver body comprises a receiving surface, which receives, at least partially, the IR radiation. One or more TPV cells are disposed on this receiving surface for converting, at least partially, the IR radiation into electric power.

The TPV conversion module, according to the present invention, is characterized in that TPV cells comprise at least a TPV cell, which include a multi-layered structure. This multi-layered structure comprises at least a first layer of organic material.

For a better understanding of the present invention, reference should be made to the detailed description reported hereinafter, taken in conjunction with the accompanying drawings in which:
figure 1 represents schematically the structure of a known TPV apparatus; and
figure 2 represents schematically the basic structure of the TPV conversion module, according to the present invention; and
figure 3 represents schematically a preferred embodiment of the TPV conversion module, according to the present invention; and
figure 4 represents schematically another preferred embodiment of the TPV conversion module, according to the present invention; and
figure 5 represents schematically the basic structure of TPV apparatus, which incorporates a TPV conversion module, according to the present invention.

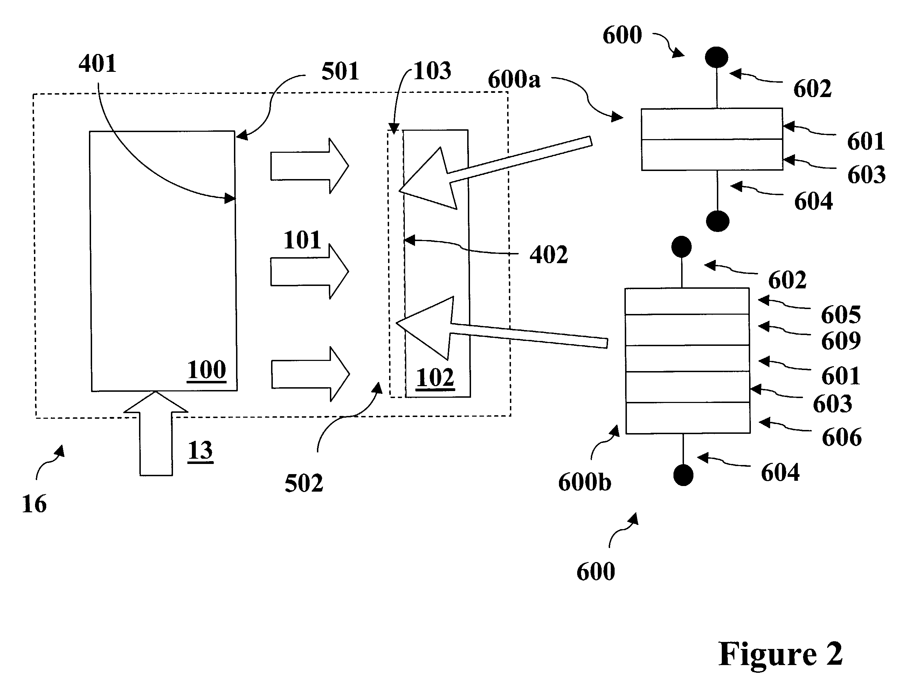

Referring to figure 2, the TPV conversion module 16, according to the present invention, generates electric power and comprises an emitter body 100, which is associated to a burner device (not shown). The burner device generates hot gases 13 that are provided with an amount of thermal power. The emitter body 100 comprises at least an emitting surface 501, which emits IR radiation 101, when the emitter body 100 is heated by the hot gases 13. The TPV conversion module 16 comprises also a receiver body 102, which is associated to the emitter body 100. The receiver body 102 comprises a receiving surface 502, which receives, at least partially, the IR radiation 101. One or more TPV cells 103 (dotted line) are disposed on the receiving surface 502 for converting, at least partially, the IR radiation 101 into electric power. The peculiarity of the TPV conversion module, according to the present invention, consists of the fact that the TPV cells 103 comprises at least a TPV cell, which includes a multi-layered structure 600. The multi-layered structure 600 comprises at least a first layer 601, made of organic material. The organic material may belongs preferably to the PPV (polyphenylenevinylene) and/or PAn (Polyaniline) and/or PA (Polyacetylene) and/or PPy (polypirrole) and/or PTh (Polythiophene) and/or P3MTh (polymethilthiophene) and/or PVCZ (Ployvinylcarbonazole) families. Preferably, the first layer 601 is doped, in order to provide the organic material with a band gap lower than 1 eV, suitable to receive the IR radiation 101. Doping materials may be atoms/molecules chemically bonded to the polymer base or fine particles physically bonded to the polymer matrix (e.g. nanostructured particles such as fullerenes). In any case, the object of the doping is to create a suitable energy gap (lower than 1 eV) between the π-ligand and π*-antiligand orbitals in the organic material of the first layer 601. In this manner, an amount of free charge carriers is generated in the first layer 601, when it receives at least a portion of IR radiation 101.

Preferably the multi-layered structure comprises a first electrode 602, associated to the layer 601. Further, the multi-layered structure 600 comprises a second layer 603 associated to the first layer 601 and a second electrode 604, associated to the second layer 603. In a preferred embodiment of the TPV conversion module (reference 600a), according to the present invention, the second layer 603 is made of organic material (preferably belonging to the PPV family) and is associated to the first layer 601, so as to constitute an p-n heterojunction. As it is known, with the term "heterojunction" it is meant a junction between two materials that may have different structure. At the interface between layers 601 and 603 (i.e. the p- and n- layers of the heterojunction), free charge carriers (holes and electrons) are generated. Then, electrodes 602 and 604 can collect these free charge carriers.

Alternatively (reference 600b) the multi-layered structure 600 may comprise a third layer 605, which is interposed between said first layer 601 and the first electrode 602. The third layer 605 may comprise advantageously an electrolitic solution (which might be in a liquid, solid or gel state) for providing an exchange of free charge carriers (mainly electrons) between the first layer 601 and the first electrode 602. In fact, ions of the electrolitic solution are able to chemically reduce the molecules of the layers 601 and, therefore, to generate free electrons that are driven towards the electrode 602. Advantageously, a fourth layer 609 may be interposed between the first layer 601 and the third layer 605. The fourth layer 609 (preferably made of Pt) works as a catalyst, aimed at improving the exchange of free charge carriers (mainly electrons) between the first layer 601 and the first electrode 602. Preferably, also a fifth layer 606 may be interposed between the second layer 603 and the second electrode 604. The fifth layer 606 (which preferably is made of TiO₂) is aimed at improving the exchange of free charge carriers (mainly electrons) between the second layer 603 and the second electrode 604.

From what described above, it appears evident that the multi-layered structure 600 is able to converts the received IR radiation into electric power and, therefore, it is able to substitute the traditional inorganic TPV cells that are commonly adopted. Further, due to the adoption of a plurality of active layers, it is able to provide a remarkably improved conversion efficiency of the TPV cell.

In a preferred embodiment to the present invention (not illustrated), the TPV conversion module 16 comprises a cooling system, which is associated to the receiver body 102. The cooling system is aimed at maintaining the operating temperature of the plurality of TPV cells 103 within a predefined temperature range. This is quite advantageous, because the TPV cells are allowed to work always at optimal operating conditions.

The use of organic TPV cells 103, and, in particular, of the multi-layered structure 600 allows adopting various advantageous configurations for the TPV conversion module 16.

According to a preferred embodiment, illustrated in figure 2, the emitter body 100 comprises at least a first flat wall 401, which includes the emitting surface 501. Accordingly, the receiver body 102 comprises at least a second flat wall 402, which includes the receiving surface 502.

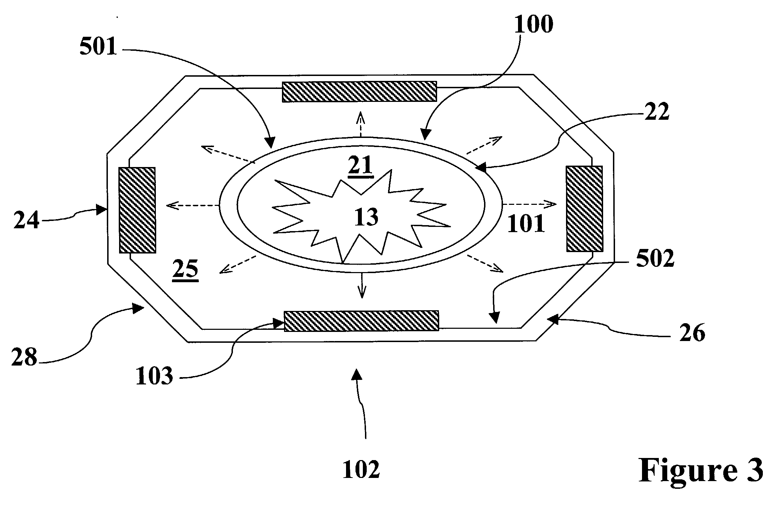

According to another preferred embodiment (figure 3), the emitter body 100 comprises at least a first through cavity 21, in which the hot gases 13 are allowed to flow. The emitter body 100 is therefore heated because of the flow of the hot gases 13. The emitter body 100 comprises also at least an external wall 22, which advantageously includes the emitting surface 501. According to the same preferred embodiment, the receiver body 102 comprises a second through cavity 25, in which the emitter body 100 is positioned. The internal wall 26 of the second through cavity 25 advantageously includes the receiving surface 502 and, therefore, it supports a plurality of TPV cells (hatched box 103) that are positioned so as to receive the IR radiation 101. Advantageously, the second through cavity 25 can be sealed so as to obtain a vacuum atmosphere inside the cavity or an atmosphere filled with a noble gas (e.g. Helium).

The emitter body 100 can advantageously comprise layers of high emissivity material such as, for example, SiC or Kanthal.

Preferably, the receiver body 102 comprises at least an external wall 28, which exchanges heat with a cooling fluid (not illustrated). The cooling fluid is advantageously supplied by the mentioned cooling system.

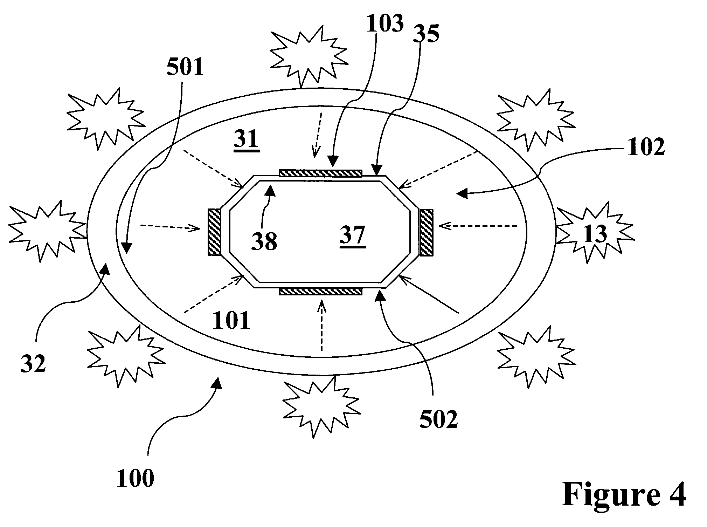

Referring to figure 4, according to another preferred embodiment of the present invention, the emitter body 100 is exposed to the flow of hot gases 13, so as to be heated. The emitter body 100 comprises a third through cavity 31. At least an internal wall 32 of the third through cavity 31 includes the emitting surface 501, which emits an IR radiation 101, when the emitter body 100 is heated by the hot gases 13. The third through cavity 31 can be sealed so as to obtain a vacuum atmosphere inside the cavity or an atmosphere filled with a noble gas (e.g. Helium).

According to the same preferred embodiment, the receiver body 102 is positioned inside the third through cavity 31, so as to be surrounded by the emitter body 100. At least an external wall 35 of the receiver body 102 includes the receiving surface 502.

The receiver body 102 comprises advantageously a fourth through cavity 37, through which a cooling fluid (not illustrated) can flow and exchange heat with at least an internal wall 38 of the fourth cavity 37. The cooling fluid can be supplied by the cooling system 104 of figure 3.

These configurations represent a substantial improvement in terms of conversion efficiency. The geometry of the emitter body 100 and the receiver body 102 can be designed, according to the needs. For example, the may have a cylindrical geometry as illustrated in figure 3 and 4 or they may have a polyedric geometry. It should be noticed that, thanks to the intrinsic flexibility of the organic TPV cells, no substantial design constraints derive from the need of disposing the TPV cells 103 on the receiving surface 502.

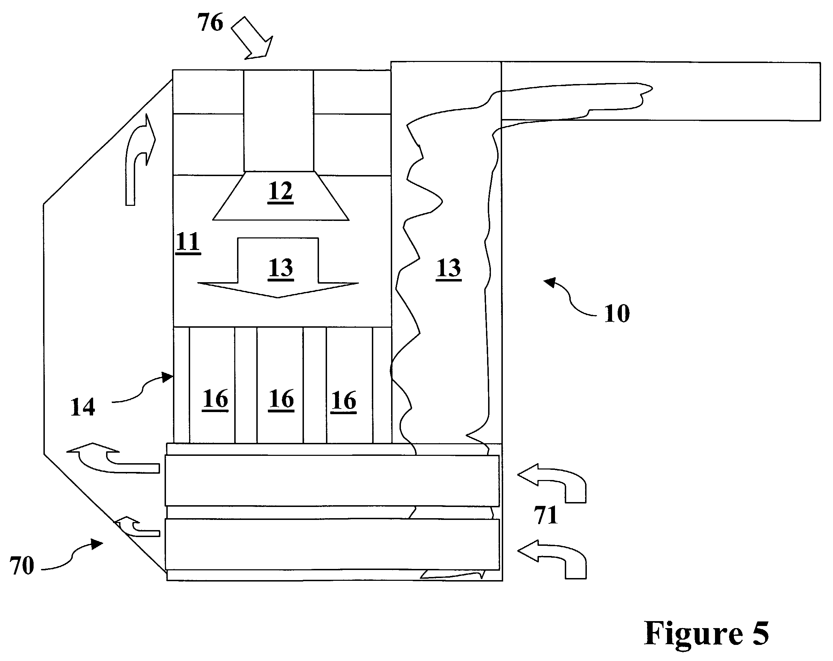

Referring now to figure 5, a preferred embodiment of a TPV apparatus (reference 10), which incorporates the TPV conversion module 16, according to the present invention, is illustrated. The TPV apparatus 10 comprises preferably a combustion chamber 11. The combustion chamber 11 comprises a burner device 12, which generates by means of the combustion of fuel 76 and combustion air 71 hot gases 13, which provide an amount of thermal power. The TPV apparatus 10 comprises also a converter assembly (globally indicated by the dotted box 14), which is associated to the combustion chamber 11. The converter assembly 14 converts into electric power at least a portion of the amount of thermal power, which is provided by the hot gases 13. The converter assembly 14 comprises one or more TPV modules 16. Preferably, the converter assembly 14 (and, therefore, the TPV conversion modules 16) may be positioned internally to the combustion chamber 11. This configuration is quite advantageous, since it allows increasing the output power of the TPV apparatus, which can be quite higher than 1 KW.

The TPV apparatus 10 comprises preferably a recuperator assembly 70. The recuperator assembly 70 can perform a pre-heating of the combustion air 71, by means of the residual heat of the hot gases 13, simply adopting exchanger tubes 73. Alternative, the burner device 12 of the TPV apparatus 20 may be advantageously provided with an auto-recuperative system (not illustrated), for directly pre-heating the combustion air 71. Therefore, the structure of the TPV apparatus 10, according to the present invention, can be remarkably simplified. Alternatively, the burner device 12 can comprise an auto-regenerative burner, such as one of those generally used in industrial kiln-drying systems. In any case, the total efficiency of the TPV apparatus 80, according to the present invention, can be further increased till to relatively high levels (around or more 20%). Moreover, the burner device 12 may comprise a burner of the flame-type or, more advantageously, of the flame-less type, so as to reduce the NOx emissions of the TPV apparatus 20.

The TPV apparatus 10 is quite advantageous because, due to its modular structure, whose size basically depends on the number of adopted TPV conversion modules, it allows to provide an output power level, which can be simply modulated according to the needs.

It has been proved in practice that the TPV conversion module, according to the present invention, allows achieving all the intended aims and objects.

Thanks to the use of organic TPV cells it is possible to reduce drastically the manufacturing costs of the TPV conversion module, ensuring in the same time high level performances. In fact, the manufacturing technologies of the organic TPV cells are relatively simple to perform and do not require sophisticated arrangements. Multi-layered structures can be fabricated with relatively low efforts. Therefore, the conversion performances of each TPV cells may be optimized.

Further, TPV cells provided with a remarkably surface may be realized: this fact implies that it possible to simplify the structure of the receiver body 102, which does not require the presence of complicated circuit arrangements, anymore. TPV organic cells, being based on the use of organic materials, are intrinsically provided with a high level of elasticity. Therefore, curved receiving surfaces 502 may be easily realized: this fact allows improving remarkably the overall efficiency of the TPV conversion module and modulating, by means of optimized layouts of the receiving surface 502, the transmitted power density, according to the needs. Finally, TPV organic cells are intrinsically characterized by a lower weight: this allows improving the assembly of a TPV conversion module 16 and more in general the assembly of TPV apparatus 10.

Finally, the practice has shown that the TPV conversion module, according to the present invention, allows designing TPV apparatuses that are able to provide remarkably improved performances both in terms of reliability and flexibility of use.

## Claims

1. A TPV conversion module comprising:
- an emitter body, which is associated to a burner device that generates hot gases provided with an amount of thermal power, said emitter body comprising at least an emitting surface, which emits IR radiation, when said emitter body is heated by the hot gases generated by said burner device; and
- a receiver body, which is associated to said emitter body, said receiver body comprising a receiving surface, which receives, at least partially, said IR radiation, one or more TPV cells being disposed on said receiving surface for converting, at least partially, said IR radiation into electric power;
**characterized in that**, said one or more TPV cells comprises at least a TPV cell, which includes a multi-layered structure, said multi-layered structure comprising at least a first layer of organic material.

2. A TPV conversion module, according to claim 1, **characterized in that** said first layer comprises materials belonging to the PPV (polyphenylenevinylene) and/or PAn (Polyaniline) and/or PA (Polyacetylene) and/or PPy (polypirrole) and/or PTh (Polythiophene) and/or P3MTh (polymethilthiophene) and/or PVCZ (Ployvinylcarbonazole) families.

3. A TPV conversion module, according to one or more of previous claims, **characterized in that** an amount of free charge carriers is generated in said first layer, when said first layer receives at least a portion of IR radiation.

4. A TPV conversion module, according to one or more of previous claims, **characterized in that** said multi-layered structure comprises:
- said first layer; and
- a first electrode associated to said first layer; and
- a second layer associated to said first layer; and
- a second electrode associated to said second layer.

5. A TPV conversion module, according to claim 4, **characterized in that** said second layer is made of organic material and is associated to said first layer, so as to constitute an p-n heterojunction.

6. A TPV conversion module, according to claim 4, **characterized in that** said multi-layered structure comprises a third layer, which is interposed between said first layer and said first electrode, said third layer comprising an electrolitic solution for providing an exchange of free charge carriers between said first layer and said first electrode.

7. A TPV conversion module, according to claim 6, **characterized in that** said multi-layered structure comprises a fourth layer, which is interposed between said first layer and said third layer, said fourth layer improving the exchange of free charge carriers between said first layer and said first electrode.

8. A TPV conversion module, according to one or more of claims from 6 to 7, **characterized in that** said multi-layered structure comprises a fifth layer, which is interposed between said second layer and said second electrode, said fifth layer improving the exchange of free charge carriers between said second layer and said second electrode.

9. A TPV conversion module, according to one or more of previous claims, **characterized in that** it comprises a cooling system, which is associated to said receiver body for maintaining the operating temperature of said plurality of TPV cells within a predefined temperature range.

10. A TPV apparatus for generating electric power comprising:
- a combustion chamber comprising a burner device, said burner device generating, by means of the combustion of fuel and combustion air, hot gases providing an amount of thermal power; and
- a converter assembly, which is associated to said combustion chamber for converting into electric power at least a portion of said amount of thermal power,
**characterized in that** said converter assembly comprises one or more TPV conversion modules, according to one or more of previous claims.
